# EUROPEAN PATENT APPLICATION

(11) **EP 3 624 185 A1**
(43) Date of publication of application: **18.03.2020**
(21) Application number: 18913993.4
(22) Date of filing: 17.07.2018
(51) Int. Cl.: H01L 23/525, H01L 21/768

(54) **ANTIFUSE, ANTIFUSE MANUFACTURING METHOD, AND MEMORY DEVICE**

(71) Applicant: Shenzhen Weitongbo Technology Co., Ltd., Shenzhen, Guangdong 518052 (CN)
(72) Inventor: WANG, Wenxuan, Shenzhen, Guangdong 518052 (CN); SHEN, Jian, Shenzhen, Guangdong 518052 (CN); WANG, Hongchao, Shenzhen, Guangdong 518052 (CN); ZHOU, Hongxing, Shenzhen, Guangdong 518052 (CN)
(74) Representative: Sticht, Andreas
(86) International application number: PCT/CN2018/095937
(87) International publication number: WO 2020/014859

(57) **Abstract**

Embodiments of the present disclosure provide an anti-fuse, a method for fabricating an anti-fuse, and a storage apparatus. The anti-fuse includes at least one anti-fuse unit. The anti-fuse unit includes: a field-effect transistor, including a substrate, and a first doping region, a second doping region and a gate electrode that are disposed on the substrate; and a first electrode, arranged on the substrate and forming an anti-fuse capacitor with the substrate, the first electrode being connected to the first doping region, and configured to break down the anti-fuse capacitor by voltage adjustment between the second doping region and the substrate and write data to the anti-fuse unit, or configured to detect a current flowing through the second doping region by voltage adjustment for the gate electrode and determine whether to write data to the anti-fuse unit. By using the first electrode and the substrate as a pair of plates of the anti-fuse capacitor, a port of the anti-fuse unit may be omitted.

## Description

### TECHNICAL FIELD

Embodiments of the present disclosure relate to the technical field of semiconductors, and in particular, relate to an anti-fuse, a method for fabricating an anti-fuse, and a storage apparatus thereof.

### BACKGROUND

Commonly used one-time programmable storage structures include an effuse, an anti-fuse or a floating gate structure.

The effuse after being programmed may suffer from physical fusion, and the fusion part may be easily observed. As a result, programmed content may be cracked, such that the effuse has a low security. Relative to the effuse, the anti-fuse after being programmed may not be obviously observed, and thus has a high security.

The floating gate structure after being programmed stores charges. However, the stored charges are easily subject to the environment and suffer from loss, and as a result, the storage may fail. Relative to the floating gate structure, in the anti-fuse after being programmed, an anti-fuse capacitor therein is broken down, and thus a stable conductive loop is formed. Therefore, the robustness is good, and the stored content is more stable.

Since the anti-fuse has the above technical merits, the anti-fuse has been widely used in the one-time programming field. The anti-fuse generally includes a plurality of anti-fuse units. One anti-fuse unit generally includes a field-effect transistor and an anti-fuse capacitor. However, the anti-fuse unit has more control ports. During controlling the anti-fuse unit, a plurality of ports needs to simultaneously accommodate the predefined requirements. As a result, the control method is complicated, such that it is unfavorable to population and application of the anti-fuse. For example, one plate of the anti-fuse capacitor is connected to one terminal of the field-effect transistor, and in this case, the control ports of the anti-fuse unit include: the other plate of the anti-fuse capacitor, the other two terminals of the field-effect transistor, the substrate of the field-effect transistor. Therefore, during control of the anti-fuse unit, the other plate of the anti-fuse unit, the other two terminals of the field-effect transistor, and the substrate of the field-effect transistor need to simultaneously accommodate the predefined requirements. As a result, the control method is relatively complicated.

### SUMMARY

Embodiments of the present application are intended to provide an anti-fuse, a method for fabricating an anti-fuse, and a storage apparatus thereof, to at least solve the above technical problem in the prior art.

In view of the above, embodiments of the present disclosure provide an anti-fuse. The anti-fuse includes at least one anti-fuse unit. The anti-fuse unit includes: a field-effect transistor, including a substrate, and a first doped region, a second doped region and a gate electrode that are disposed on the substrate; and a first electrode, arranged on the substrate and forming an anti-fuse capacitor with the substrate, the first electrode being connected to the first doped region, and configured to break down the anti-fuse capacitor by voltage adjustment between the second doped region and the substrate and write data to the anti-fuse unit, or configured to detect a current flowing through the second doped region by voltage adjustment for the gate electrode and determine whether data is written to the anti-fuse unit.

Optionally, in any one embodiment of the present disclosure, the anti-fuse unit further includes a first insulation layer. The first insulation layer is disposed between the first electrode and the substrate.

Optionally, in any one embodiment of the present disclosure, the anti-fuse unit further includes a second insulation layer. The second insulation layer is disposed between the gate electrode and the substrate.

Optionally, in any one embodiment of the present disclosure, the second insulation layer and the first insulation layer are formed simultaneously.

Optionally, in any one embodiment of the present disclosure, the first electrode is a polysilicon plate, and/or the gate electrode is a polysilicon plate.

Optionally, in any one embodiment of the present disclosure, the anti-fuse unit further includes a first metal connection hole. The first doped region and the first electrode are connected by the first metal connection hole.

Optionally, in any one embodiment of the present disclosure, the first metal connection hole is a shared connection hole. The first doped region and the first electrode sharing the shared connection hole to be connected to the first doped region and the first electrode by the shared connection hole.

Optionally, in any one embodiment of the present disclosure, the anti-fuse unit further includes a second metal connection hole and a metal connection line layer. The second metal connection hole is configured to connect the second doped region to the metal connection line layer, or configured to connect the gate electrode to the metal connection line layer.

Optionally, in any one embodiment of the present disclosure, the anti-fuse further includes an isolation unit. The isolation unit being configured to isolate the anti-fuse capacitor from an adjacent anti-fuse capacitor thereof.

Optionally, in any one embodiment of the present disclosure, a plurality of anti-fuse units is arranged in rows and columns to form an anti-fuse array. Two rows or two columns of adjacently disposed in the anti-fuse array share one isolation unit.

Optionally, in any one embodiment of the present disclosure, the isolation unit is a shallow trench isolation unit or a third doped region.

Optionally, in any one embodiment of the present disclosure, if the isolation unit is the shallow trench isolation unit, a contact position between the shallow trench isolation unit and the anti-fuse capacitor includes an insulation portion.

Optionally, in any one embodiment of the present disclosure, if the isolation unit is the third doped region, the substrate is in contact with the third doped region, and the third doped region is provided with an external port such that the substrate is connected to the outside by the external port.

Optionally, in any one embodiment of the present disclosure, if the substrate is a P-type substrate, the first doped region and the second doped region are both N-type doped; or if the substrate is an N-type substrate, the first doped region and the second doped region are both P-type doped.

Optionally, in any one embodiment of the present disclosure, the substrate is connected to a fixed voltage.

Embodiments of the present disclosure further provide a method for fabricating the above anti-fuse. The method includes: machining a substrate on a base by a front-end-of-line device machining process, and forming a first electrode, a first doped region, a gate electrode and a second doped region on the substrate, the first doped region, the second doped region and the gate electrode forming a field-effect transistor, and the first electrode and the substrate forming the anti-fuse; and electrically connect the first doped region to the first electrode by a back-end-of-line metal machining process.

Optionally, in any one embodiment of the present disclosure, the forming the first electrode and the gate electrode on the substrate includes: forming the first electrode and the gate electrode on the substrate by an electrode machining process.

Optionally, in any one embodiment of the present disclosure, the forming the first electrode and the gate electrode on the substrate by the electrode machining process includes: by a dual gate process, forming a first insulation layer and a second insulation layer simultaneously on the substrate, and forming the gate electrode and the first electrode simultaneously, the first electrode being disposed above the first insulation layer, and the gate electrode being disposed above the second insulation layer.

Optionally, in any one embodiment of the present disclosure, the method further includes: forming a shallow trench isolation unit by a shallow trench isolation process, the shallow trench isolation unit being configured to isolate the anti-fuse capacitor from an adjacent anti-fuse capacitor thereof.

Optionally, in any one embodiment of the present disclosure, the electrically connecting the first doped region to the first electrode by the back-end-of-line machining process includes: forming a first metal connection hole by the back-end-of-line machining process to connect the first doped region to the first electrode by the first metal connection hole.

Optionally, in any one embodiment of the present disclosure, the first metal connection hole is a shared connection hole. The first doped region and the first electrode sharing the shared connection hole to be connected to the first doped region and the first electrode by the shared connection hole.

Optionally, in any one embodiment of the present disclosure, the method further includes: forming a second metal connection hole and a connection line layer by the back-end-of-line machining process, the second metal connection hole being configured to connect the second doped region to the metal connection line layer, or configured to connect the gate electrode to the metal connection line layer.

Embodiments of the present application further provide a storage apparatus. The storage apparatus includes the above described anti-fuse.

In the technical solutions according to the embodiments of the present disclosure, the anti-fuse includes at least one anti-fuse unit. The anti-fuse unit includes: a field-effect transistor, including a substrate, and a first doping region, a second doping region and a gate electrode that are disposed on the substrate; and a first electrode, arranged on the substrate and forming an anti-fuse capacitor with the substrate, the first electrode being connected to the first doping region, and configured to break down the anti-fuse capacitor by voltage adjustment between the second doping region and the substrate and write data to the anti-fuse unit, or configured to detect a current flowing through the second doping region by voltage adjustment for the gate electrode and determine whether to write data to the anti-fuse unit. By using the first electrode and the substrate as a pair of plates of the anti-fuse capacitor, a port of the anti-fuse unit may be omitted. Since the field-effect transistor is connected to the anti-fuse capacitor, data may be written to the anti-fuse unit or data written to the anti-fuse unit may be read by adjusting the voltage of the gate electrode of the field-effect transistor and adjusting the voltage difference between the second doped region and the substrate, such that the operations of the anti-fuse are simpler.

### BRIEF DESCRIPTION OF THE DRAWINGS

For clearer description of the technical solutions in embodiments of the present disclosure or in the related art, hereinafter, drawings that are to be referred for description of the embodiments or the related art are briefly described. Apparently, the drawings described hereinafter merely illustrate some embodiments of the present disclosure. Persons of ordinary skill in the art may also derive other drawings based on the drawings described herein without any creative effort.
FIG. 1 is a schematic structural diagram of an anti-fuse according to a first embodiment of the present disclosure;
FIG. 2a is an array layout corresponding to the anti-fuse as illustrated in FIG. 1;
FIG. 2b is a schematic structural diagram of an anti-fuse unit as illustrated in FIG. 2a;
FIG. 3 is a schematic structural diagram of another anti-fuse according to a second embodiment of the present disclosure;
FIG. 4 is an array layout corresponding to the anti-fuse as illustrated in FIG. 3;
FIG. 5 is a schematic structural diagram of still another anti-fuse according to a third embodiment of the present disclosure;
FIG. 6 is a schematic structural diagram of yet still another anti-fuse according to a fourth embodiment of the present disclosure.

### Reference numerals and denotations thereof:

101-base; 102-substrate; 103-first doped region; 104-second doped region; 105-gate electrode; 106-first electrode; 107-first insulation layer; 108-second insulation layer; 109-first metal connection hole; 110-second metal connection hole; 111-metal connection line layer; 112-shallow trench isolation unit; 113-insulation portion; 114-field-effect transistor; 115-anti-fuse capacitor; 116-third doped region; 117-external port; 21-anti-fuse unit

### DETAILED DESCRIPTION

Practice of the present disclosure is described in detail with reference to drawings and specific embodiments, such that the practice of addressing the technical problem using the technical means according to the present disclosure and achieving the technical effects may be better understood and conducted.

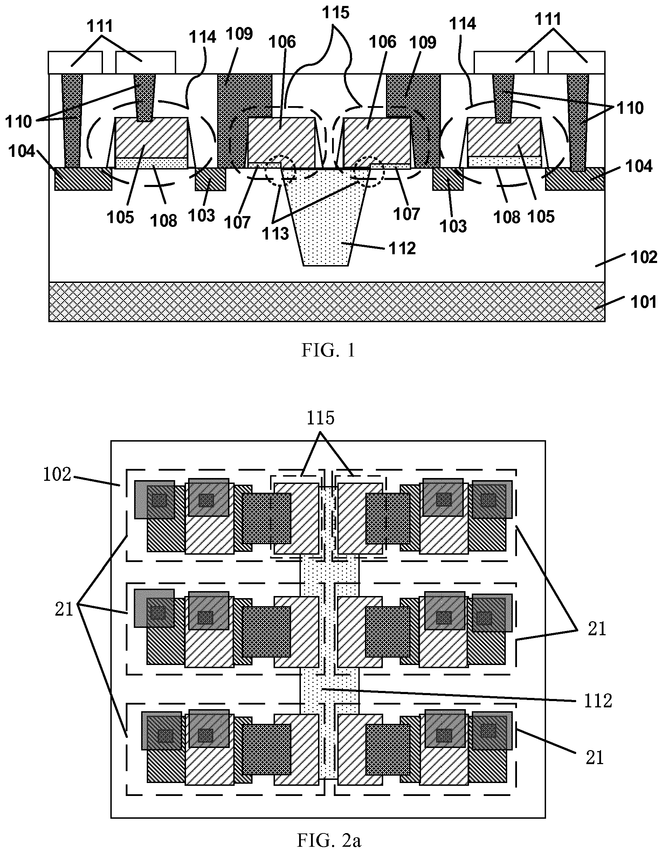

FIG. 1 is a schematic structural diagram of an anti-fuse according to a first embodiment of the present disclosure.

In practice, the anti-fuse may include one or a plurality of anti-fuse units. For example, as illustrated in FIG. 1, the anti-fuse includes two anti-fuse units. The two anti-fuse units are symmetrically arranged on two sides of a shallow trench isolation unit 112. As illustrated in FIG. 1, each anti-fuse unit includes a field-effect transistor 114 and a first electrode 104. The field-effect transistor 114 includes a substrate 102 and a first doped region 103, a second doped region 104 and a gate electrode 105 that are disposed on the substrate 102. The anti-fuse unit further includes a first electrode 106. The first electrode 016 is disposed on the substrate 102, and forms an anti-fuse capacitor 115 with the substrate 102. The first electrode 106 and the substrate 106 are used as a pair of plates of the anti-fuse capacitor 115. In specific practice, the field-effect transistor 114 is an NMOS transistor. Nevertheless, the field-effect transistor 114 may also be another type of field-effect transistor.

Specifically, in this embodiment, the first doped region 103 is connected to the first electrode 106 (for example, the first doped region 103 is connected to the first electrode 106 by a first metal connection hole 109 as illustrated in FIG. 1); the anti-fuse unit may be connected to an external control chip or control circuit; during writing data to the anti-fuse unit, data writing may be controlled by the control chip or control circuit to adjust a voltage difference between the second doped region 104 and the substrate 102 and adjust a voltage of the gate electrode 105 (which is also referred to as a second electrode), such that the anti-fuse capacitor 115 is broken down and data is written to the anti-fuse unit; or during determining data is written to the anti-fuse unit, the control chip or control circuit may control voltage adjustment for the gate electrode 105 and detect a current flowing through the second doped region 104, such that whether data is written to the anti-fuse unit is determined.

In the anti-fuse according to this embodiment, the first electrode 106 and the substrate 102 are respectively used as one of the plates of the anti-fuse capacitor 115, and thus one port of the anti-fuse capacitor 115 may be omitted (that is, the other plate of the anti-fuse capacitor described in the background). In this way, the size of the anti-fuse unit is reduced, and thus the size of the anti-fuse is reduced.

In addition, in this embodiment, the voltage difference between the second doped region 104 of the field-effect transistor 114 and the substrate 102 and the voltage of the gate electrode 105 are adjusted, such that data is written to the anti-fuse unit; or data in the anti-fuse unit is read, such that operations of the anti-fuse are simpler.

Exemplarily, in a specific application scenario, during writing data to one anti-fuse unit in the anti-fuse, a first voltage may be connected to the gate electrode 105 of the anti-fuse unit, such that a sufficient current channel is generated in the field-effect transistor while the field-effect transistor 114 is turned on, and hence a current which is sufficiently great to break down the anti-fuse capacitor 115 may flow through the field-effect transistor; and a second voltage may also be connected to the second doped region 104 of the anti-fuse unit, such that the voltage difference between the second doped region 104 and the substrate 102 is a predetermined breakdown voltage (in this process, the substrate 102 or a third doped region 116 hereinafter may be connected to the ground or at a 0 level).

On the premise that a current which is sufficiently great to break down the anti-fuse capacitor 115 may flow through the field-effect transistor, when the voltage difference between the second doped region 104 and the substrate 102 is the predetermined breakdown voltage, a voltage difference that may break down the anti-fuse capacitor 115 may be generated between the first electrode 106 and the substrate 102 to write data to the anti-fuse unit. For example, the current may flow through the first doped region 103 to the first electrode 106, and then break down the anti-fuse capacitor 115 to write data to the anti-fuse unit. Nevertheless, the current may also flow in a reverse direction. If the anti-fusec capacitor 115 is broken down, it indicates that the data written to the anti-fuse unit is 0, or the data written to the anti-fuse unit is 1, which is not limited in this embodiment.

In addition, since the first doped region 103 is connected to the first electrode 106 (for example, the first doped region 103 is connected to the first electrode 106 by the first metal connection hole 109 as illustrated in FIG. 1), if the anti-fuse capacitor 115 is broken down, the first doped region 103 may be directly connected to the substrate 102; and if the anti-fuse capacitor 115 is not broken down, the first doped region 103 is connected to the first electrode 106, the first electrode 106 and the substrate 102 are used as a pair of plates of the anti-fuse capacitor, and thus the first doped region 103 is connected to the substrate 102 by the anti-fuse capacitor 115. Under the two circumstances where the anti-fuse capacitor is broken down and the anti-fuse capacitor is not broken down, currents flowing through the third doped region are different. As a result, currents flowing through the second doped region 104 are also different. Therefore, when data written to the anti-fuse unit needs to be read, the voltage of the gate electrode 105 may be adjusted, such that the field-effect transistor 114 is turned on. In the meantime, the second doped region 104 is externally connected to a detection circuit, such that the detection circuit detects the current flowing through the second doped region 104 and determines whether the anti-fuse capacitor 105 is turned on. In this way, whether data is written to the anti-fuse unit is determined and the data is read.

In addition, in this embodiment, the substrate 102 may be connected to a fixed voltage (for example, a 0 V voltage) to ensure that a voltage of the plate of the anti-fuse capacitor is not abruptly changed, such that during writing data to the anti-fuse unit, the anti-fuse capacitor 115 is more easily broken down. Further, during reading data written to the anti-fuse unit, it is ensured that the current flowing through the second doped region 104 is stable.

This embodiment sets no limitation to the voltage value of the fixed voltage to which the substrate 102 is connected, the voltage value of the first voltage to which the gate electrode 105 is connected and the voltage value of the second voltage to which the second doped region 104 is connected, as long as it is ensured that the anti-fuse capacitor 115 may be broken down. For example, when the voltage value of the fixed voltage to which the substrate 102 is connected is low (for example, 0 V), for breakdown of the anti-fuse capacitor 115, under the circumstance where the first voltage ensures that the field-effect transistor 114 is turned on and provides sufficient current channels, the voltage value of the second voltage may be higher than the voltage value of the fixed voltage to which the substrate 102 is connected; or when the voltage value of the fixed voltage to which the substrate 102 is high (for example, 10 V), under the circumstance where the first voltage ensures that the field-effect transistor 114 is turned on and provides sufficient current channels, the voltage value of the second voltage may be lower than the voltage value of the fixed voltage to which the substrate 102 is connected. Referring to FIG. 1, a method for fabricating the anti-fuse is described briefly hereinafter.
(1) The substrate 102 is machined on the base 101 by a front-end-of-line device machining process, and the first electrode 106, the first doped region 103, the gate electrode 105 and the second doped region 104 are formed on the substrate 102. The first doped region, the second doped region and the gate electrode form a field-effect transistor, and the first electrode and the substrate form the anti-fuse.

Specifically, in this embodiment, the base 101 may be a wafer (for example, a silicon wafer) or a carrier for machining other semiconductor devices, which is not limited in this embodiment. Since the field-effect transistor 114 is an NMOS transistor, a doped region having a P-type device well is machined on the base 101. A dopant element may a P-type dopant element such as boron, such that the substrate 102 is a P-type substrate. Further, the first doped region 103, the second doped region 104 of the field-effect transistor 114 are machined on the P-type substrate. The first doped region 103 and the second doped region 104 are both N-type doped. A dopant element may be an N-type dopant element such as phosphorus.

In this embodiment, the first doped region 103 is a source of the NMOS transistor, and the second doped region 104 is a drain of the NMOS transistor. Nevertheless, in other implementations of the present disclosure, the first doped region 103 may be the drain of the NMOS transistor, and the second doped region 104 may be the source of the NMOS transistor, which are not limited in the present disclosure.

In this embodiment or other embodiments, a gate electrode 105 is further formed between the first doped region 103 and the second doped region 104. The gate electrode 105 may be specifically a polysilicon gate electrode. A gate oxide layer serving as a second insulation layer 108 may also be disposed between the gate electrode 105 and the substrate 102, to form an NMOS transistor, that is, the above described field-effect transistor 114.

In this embodiment, a first insulation layer 107 may also be disposed between the first electrode 106 and the substrate 102 to serve as a medium of the anti-fuse capacitor 115, and the first insulation layer 107 may be a gate oxide layer.

During machining, the first electrode and the gate electrode may be formed on the substrate by an electrode machining process.

Specifically, when the second insulation layer 108 and the first insulation layer 107 are made of the same material, and the first electrode 106 and the gate electrode 105 are made of different materials, by a MOS standard dual gate process, the second insulation layer 108 and the first insulation layer 107 may be simultaneously formed, and then the gate electrode 105 and the first electrode 106 are simultaneously formed. The first electrode is disposed above the first insulation layer, and the gate electrode is disposed above the second insulation layer, such that the anti-fuse according to the present disclosure may be obtained only by a machining process for machining a MOS transistor. In this way, additional processes such as finishing are not needed, thereby saving the cost.

Further, if the second insulation layer 108 and the first insulation layer 107 are both a gate oxide, a thickness of the first insulation layer 107 may be less than that of the second insulation layer 108. For example, the second insulation layer 108 is a thick gate oxide layer, and the first insulation layer 107 is a thin gate oxide layer. The terms "thin" and "thick" are merely relatively defined.

In this embodiment, the current for breaking down the anti-fuse capacitor 115 is provided by the field-effect transistor 114. If the anti-fuse capacitor 115 needs to be broken down, the field-effect transistor 114 needs to provide a sufficient current. A greater current signifies that the second doped region 104 of the field-effect transistor 114 needs to be connected to a greater voltage. Since the second insulation layer 108 is a thick gate oxide layer, it is thus ensured that the field-effect transistor 114 is not broken down while providing a current that is sufficient to break down the anti-fuse capacitor 115.

In addition, since the anti-fuse capacitor 115 needs to be broken down when data is to be written to the anti-fuse unit. When the first insulation layer 107 is a thin gate oxide layer, a smaller voltage or current may break down the anti-fuse capacitor 115, such that the anti-fuse capacitor 115 is easily broken down. In this way, the difficulty in writing data to the anti-fuse unit is low.

(2) The first electrode 106 is connected to the first doped region 103 by a back-end-of-line machining process on the basis of the front-end-of-line machining, and an externally connectable port such as a gate port and a drain port may be obtained by metal machining.

In this embodiment, specifically, a metal connection hole (contact) is formed by the back-end-of-line metal machining process. The anti-fuse unit further includes the first metal connection hole 109. The first doped region 103 is connected to the first electrode 106 by the first metal connection hole 109.

In this embodiment, the process for forming the metal connection hole is briefly described hereinafter. The second metal connection hole and the shared connection hole hereinafter may be formed by the same back-end-of-line machining process with the first metal connection hole. Specifically, an insulation layer is added on the top of a semifinished product obtained by the front-end-of-line device machining process, etching is carried out at a predetermined position to obtain a through hole penetrating through the insulation layer and reaching the gate electrode, the first doped region and the second doped region, and a metal medium is filled in the through hole to obtain the metal connection hole.

By disposing the first metal connection hole 109, the first doped region 103 may be connected to the first electrode directly at the back-end-of-line metal machining stage. In this case, upon completion of the back-end-of-line metal machining stage, there is no need to additionally arrange an external connection, such that the structure of the anti-fuse unit is simpler and the machining is more convenient.

Further, as illustrated in FIG. 1, the first metal connection hole 109 may be a shared connection hole (shared contact). The shared connection hole is a metal connection hole shared by the first doped region 103 and the first electrode 106. Different from a common metal connection hole, the shared connection hole imposes a high requirement on process precision. However, one shared connection hole occupies a smaller area relative to two first metal connection holes. Use of the shared connection hole may reduce the size of the anti-fuse unit, and hence reduce the area occupied by the anti-fuse unit.

Nevertheless, in this embodiment, other metal connection holes may also be used, for example, the metal connection hole in a third embodiment hereinafter, as long as the metal connection hole may connect the first doped region 103 to the first electrode 106, which is not limited in this embodiment. Nevertheless, in this embodiment, the anti-fuse may further include a metal connection hole for another purpose.

In this embodiment, as illustrated in FIG. 1, in the back-end-of-line metal machining process, a second connection hole 110 and a metal connection line layer 111 may also be formed by the back-end-of-line metal machining process. That is, the anti-fuse unit may further include the second connection hole 110 and the metal connection line layer 111. The second metal connection hole 110 is configured to connect the second doped region 104 to the metal connection line layer 111, or configured to connect the gate electrode 105 to the metal connection line layer 111, such that the second doped region 104 may be connected to the outside by the metal connection line layer 111 to form a drain. The gate electrode 105 may be connected to the outside by the metal connection line layer 111 to form a gate.

Nevertheless, in this embodiment, FIG. 1 merely schematically illustrates the first metal connection hole 109, the second metal connection hole 110 and the metal connection line layer 111. However, the number of first metal connection holes 109, the number of second metal connection holes 110 and the number of metal connection layers 111 are not limited.

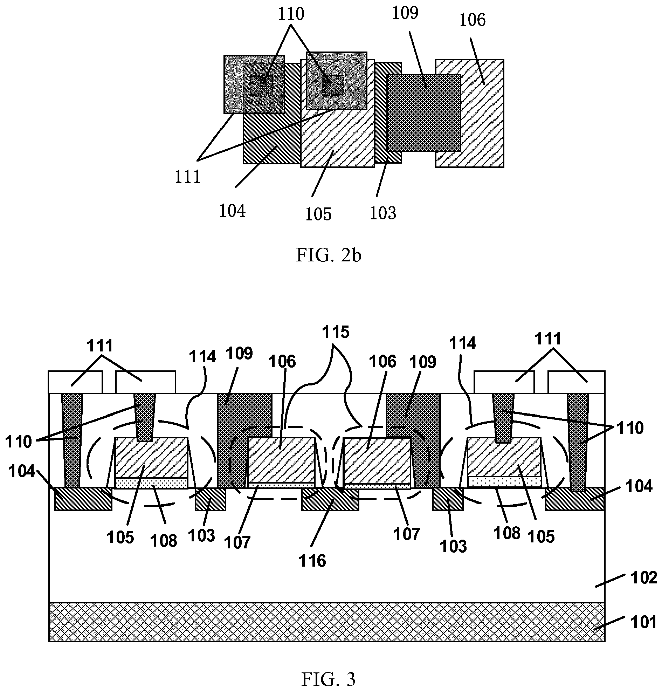

In addition, in this embodiment, FIG. 2a is an array layout of the anti-fuse corresponding to the anti-fuse in FIG. 1 according to an embodiment of the present disclosure, and FIG. 2b is a schematic structural diagram of an anti-fuse unit as illustrated in FIG. 2a. It should be noted that the structural diagram in FIG. 1 is a perspective view along a horizontal direction relative if reference is made to the array layout as illustrated in FIG. 2a.

As illustrated in FIG. 1, the anti-fuse includes two exemplary anti-fuse units that are symmetrically disposed. That is, two anti-fuse capacitors 115 and two field-effect transistors 114 are symmetrically disposed. The field-effect transistor 114 disposed on the left side is electrically connected to the anti-fuse capacitor 115 disposed on the left side, and the field effect transistor 114 disposed on the right side is electrically connected to the anti-fuse capacitor 115 disposed on the right side. There is a need to ensure that no interference is present between the two sides.

For the purpose that the anti-fuse capacitor 115 disposed on the left side does not interfere with the anti-fuse capacitor 115 disposed on the right side in the two anti-fuse units in FIG. 1, in this embodiment, the anti-fuse further includes an isolation unit. The isolation unit is configured to isolate two adjacently disposed anti-fuse capacitors 115, such that the two adjacently disposed anti-fuse capacitors 115 do not interfere with each other and may normally operate. In this embodiment, the isolation unit is formed by the front-end-of-line machining process.

In addition, if the anti-fuse array includes two rows or two columns of anti-fuse capacitors that are adjacently disposed, the two rows or two columns of anti-fuse capacitors that are adjacently disposed share one isolation unit.

Correspondingly, in the array layout of the anti-fuse in FIG. 2a, six anti-fuse units 21 are included, and the six anti-fuse units in FIG. 2a form a determinant array layout having three rows and two columns. The two columns of anti-fuse units are symmetrically disposed. Each anti-fuse unit includes an anti-fuse capacitor and a field-effect transistor. In this way, the array layout as illustrated in FIG. 2a includes totally six anti-fuse capacitors 115 that are adjacently disposed in two columns. These six anti-fuse capacitors may be divided into three groups on the basis of the number of columns. These three groups of anti-fuse capacitors 115 may share one isolation unit. FIG. 1 merely illustrates two anti-fuse capacitors 115 and two field-effect transistors 114.

Specifically, in this embodiment, the isolation unit illustrated in FIG. 1 may be a shallow trench isolation unit 112. The shallow trench isolation unit 112 may be formed on the substrate by a shallow trench isolation (STI) process. In the shallow trench isolation process, a trench is formed by subjecting a silicon nitride mask to processes such as deposition, patterning and silicon etching, and a oxide is filled into the trench and deposited therein, such that the anti-fuse capacitor is isolated from adjacent anti-fuse capacitors thereof.

In this embodiment, for the purpose that the anti-fuse capacitor 115 is more easily broken down, as illustrated in FIG. 1, an insulation portion 113 is disposed at a contact position between the shallow trench isolation unit 112 and the anti-fuse capacitor 115. The insulation portion 113 is configured to reduce the difficulty in breaking down the anti-fuse capacitor, such that the difficulty in writing data to the anti-fuse unit is lowered.

In this embodiment, the insulation portion 113 may be specifically an oxidation recess (divot) formed at an intersection position between the shallow trench isolation unit 112 and the anti-fuse capacitor 115. Relative to the first insulation layer 107, a gate oxide layer at the oxidation recess (divot) is thinner, such that the difficulty in breaking down the anti-fuse capacitor 115 is lowered, and thus the difficulty in writing data to the anti-fuse unit is lowered. In addition, since the oxidation recess (divot) is a small-sized recess, the shape of the recess causes electric field distribution of the oxidation recess (divot) is more concentrated relative to other positions (for example, the first insulation layer 107), such that the gate oxide layer at the oxidation recess (divot) is more easily broken down likewise. In this way, the difficulty in breaking down the anti-fuse capacitor 115 is lowered, and the difficulty in writing data to the anti-fuse unit is lowered.

Nevertheless, in other implementations according to the present disclosure, the insulation unit may also be an oxide insulation layer. The oxide insulation layer may be practiced by a field oxide process. The isolation unit according to the present disclosure is not limited in this embodiment as long as the isolation unit may isolate two adjacently disposed anti-fuse capacitors.

Nevertheless, FIG. 2a merely schematically illustrates a pattern layout of the anti-fuse. A person skilled in the art may determine array layouts of other anti-fuses on the basis of the array layout illustrated in FIG. 2a, for example, array layouts derived by extension along horizontal and vertical directions on the basis of the array layout in FIG. 2a, which also falls within the protection scope of the present disclosure. The number and positions of anti-fuse capacitors 115 and corresponding field-effect transistors 114 thereof may be flexibly configured on the basis of the actual needs.

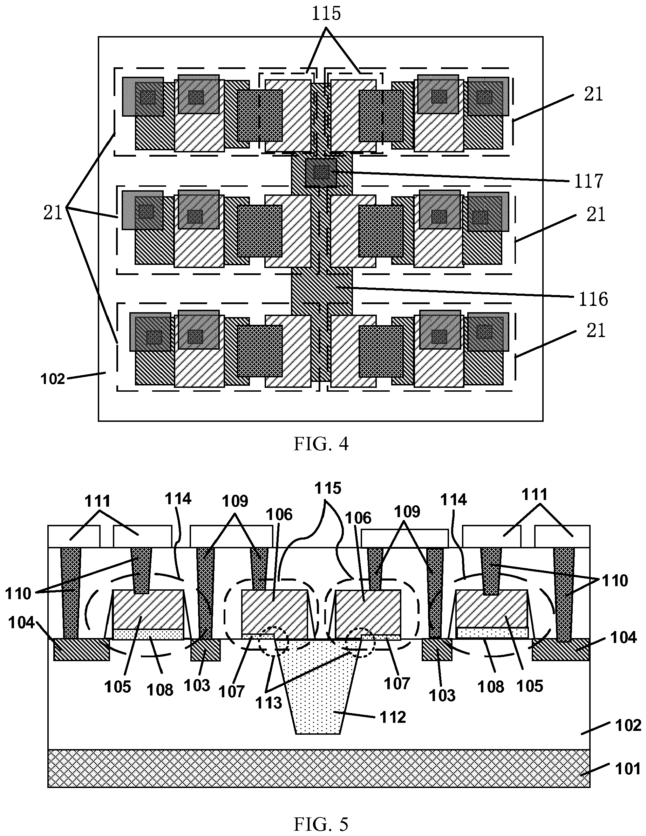

FIG. 3 is a schematic structural diagram of another anti-fuse according to a second embodiment of the present disclosure, and FIG. 4 is an array layout corresponding to the anti-fuse in FIG. 3. It should be noted that if reference is made to the array layout illustrated in FIG. 4, the structural diagram in FIG. 3 is a perspective view along a horizontal direction in FIG. 4. The anti-fuse illustrated in FIG. 3 is different from the anti-fuse illustrated in FIG. 1 in that the isolation unit in FIG. 3 is formed by doping, which may be considered as the third doped region 116.

Specifically, in this embodiment, the doping type of the third doped region 116 may be the same as, or may be different from the doping type of the first doped region 103 or the second doped region 104, as long as two adjacently disposed anti-fuse capacitors 115 are isolated, and the anti-fuse capacitor 115 may be broken down. In addition, in this embodiment, since a doping concentration of the third doped region 116 is higher than that of the substrate, a current having a high magnitude may be provided by the third doped region 116. The current having a high magnitude causes the anti-fuse capacitor 15 to be more easily broken down.

In addition, in this embodiment, an external port 117 is disposed in the third doped region 116, such that the substrate 102 is connected to the outside by the external port 117, and thus the substrate 102 is electrically connected to an external circuit (for example, the control chip or the control circuit) of the anti-fuse. For example, the substrate 102 is connected to a fixed voltage by the external port 117.

Further, as illustrated in FIG. 4, like FIG. 2a, FIG. 4 likewise illustrates six anti-fuse units. Distribution of these six anti-fuse units is the same as that illustrated in FIG. 2a, and the structure of the anti-fuse units is also the same as that of the anti-fuse units in FIG. 2a. Three groups of anti-fuse capacitors 115 disposed thereon also share one third doped region 116. An external port 117 disposed on the third doped region 116 is likewise shared by the three groups of anti-fuse capacitors 115. FIG. 3 merely illustrates two anti-fuse capacitors 115 and two field-effect transistors 114.

FIG. 5 is a schematic structural diagram of still another anti-fuse according to a third embodiment of the present disclosure, and FIG. 5 illustrates a schematic structural diagram of an anti-fuse obtained by the back-end-of-line metal machining.

In this embodiment, FIG. 5 is different from FIG. 1 in that the first metal connection hole 109 for connecting the first doped region 103 and the first electrode 106 may also be two separated metal sub-connection holes. One ends of the two metal sub-connection holes are respectively connected to the first doped region 103 and the first electrode 106, and the other ends of the two metal sub-connection holes are connected by the metal connection line layer 111, such that the first doped region 103 is connected to the first electrode 106. Relative to the above scenario where the first doped region 103 is connected to the first electrode 106 by the shared connection hole, in this embodiment, by the two separated metal sub-connection holes, the anti-fuse according to the present disclosure may likewise fabricated in a platform which does not supports the machining process of the shared connection hole.

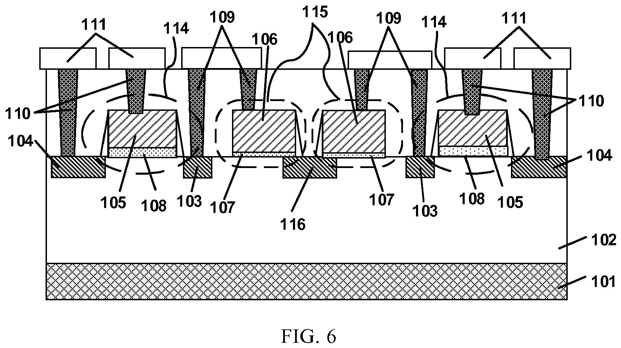

FIG. 6 is a schematic structural diagram of yet still another anti-fuse according to a fourth embodiment of the present disclosure. In this embodiment, different from FIG. 5, the isolation unit in FIG. 5 is the shallow trench isolation unit 112, whereas an isolation unit in FIG. 6 is the third doped region 116.

An embodiment of the present disclosure further provides a storage apparatus. The storage apparatus includes the above described anti-fuse.

It should be noted that the above description of the number or quantity is merely intended to give clear interpretations for the embodiments of the present disclosure, rather than particular limitations.

In addition, a person skilled in the art should understand the above division of units and modules is only an exemplary one, and if the apparatus is divided into other units or modules or not divided, the technical solution shall also fall within the protection scope of the present disclosure as long as the information object has the above functions.

Although the preferred embodiments of the present disclosure are described above, once knowing the basic creative concept, a person skilled in the art can make other modifications and variations to these embodiments. Therefore, the appended claims are intended to be construed as covering the exemplary embodiments and all the modifications and variations falling within the scope of the present disclosure. Obviously, a person skilled in the art can make various modifications and variations to the present disclosure without departing from the spirit and scope of the present disclosure. In this way, the present disclosure is intended to cover the modifications and variations if they fall within the scope of the appended claims of the present disclosure and equivalent technologies thereof.

## Claims

1. An anti-fuse, comprising at least one anti-fuse unit, the anti-fuse unit comprises:
a field-effect transistor, comprising a substrate, a first doped region, a second doped region and a gate electrode, wherein the first doped region, the second doped region and the gate electrode are disposed on the substrate; and
a first electrode, arranged on the substrate and forming an anti-fuse capacitor with the substrate, the first electrode is connected to the first doped region, and configured to break down the anti-fuse capacitor by voltage adjustment between the second doped region and the substrate and write data to the anti-fuse unit, or configured to detect a current flowing through the second doped region by voltage adjustment for the gate electrode and determine whether data is written to the anti-fuse unit.

2. The anti-fuse according to claim 1, wherein the anti-fuse unit further comprises a first insulation layer, the first insulation layer is disposed between the first electrode and the substrate.

3. The anti-fuse according to claim 2, wherein the anti-fuse unit further comprises a second insulation layer, the second insulation layer is disposed between the gate electrode and the substrate.

4. The anti-fuse according to claim 3, wherein the second insulation layer and the first insulation layer are formed simultaneously.

5. The anti-fuse according to any one of claims 1 to 4, wherein the first electrode is a polysilicon plate, and/or the gate electrode is a polysilicon plate.

6. The anti-fuse according to any one of claims 1 to 5, wherein the anti-fuse unit further comprises a first metal connection hole, the first doped region and the first electrode are connected by the first metal connection hole.

7. The anti-fuse according to claim 6, wherein the first metal connection hole is a shared connection hole, the first doped region and the first electrode sharing the shared connection hole to be connected to the first doped region and the first electrode by the shared connection hole.

8. The anti-fuse according to claim 6, wherein the anti-fuse unit further comprises a second metal connection hole and a metal connection line layer, the second metal connection hole is configured to connect the second doped region to the metal connection line layer, or configured to connect the gate electrode to the metal connection line layer.

9. The anti-fuse according to any one of claims 1 to 8, further comprising an isolation unit, the isolation unit is configured to isolate the anti-fuse capacitor from an adjacent anti-fuse capacitor thereof.

10. The anti-fuse according to claim 9, wherein a plurality of anti-fuse units is arranged in rows and columns to form an anti-fuse array, two rows or two columns of adjacently disposed anti-fuse capacitors in the anti-fuse array sharing one isolation unit.

11. The anti-fuse according to claim 9, wherein the isolation unit is a shallow trench isolation unit or a third doped region.

12. The anti-fuse according to claim 11, wherein if the isolation unit is the shallow trench isolation unit, a contact position between the shallow trench isolation unit and the anti-fuse capacitor comprises an insulation portion.

13. The anti-fuse according to claim 11, wherein if the isolation unit is the third doped region, the substrate is in contact with the third doped region, and the third doped region is provided with an external port such that the substrate is connected to the outside by the external port.

14. The anti-fuse according to any one of claims 1 to 13, wherein if the substrate is a P-type substrate, the first doped region and the second doped region are both N-type doped; or
if the substrate is an N-type substrate, the first doped region and the second doped region are both P-type doped.

15. The anti-fuse according to any one of claims 1 to 14, wherein the substrate is connected to a fixed voltage.

16. A method for fabricating an anti-fuse, comprising:
machining a substrate on a base by a front-end-of-line device machining process, and forming a first electrode, a first doped region, a gate electrode and a second doped region on the substrate, the first doped region, the second doped region and the gate electrode form a field-effect transistor, and the first electrode and the substrate form the anti-fuse; and
electrically connect the first doped region to the first electrode by a back-end-of-line metal machining process.

17. The method according to claim 16, wherein the forming the first electrode and the gate electrode on the substrate comprises: forming the first electrode and the gate electrode on the substrate by an electrode machining process.

18. The method according to claim 17, wherein the forming the first electrode and the gate electrode on the substrate by the electrode machining process comprises: by a dual gate process, forming a first insulation layer and a second insulation layer simultaneously on the substrate, and forming the gate electrode and the first electrode simultaneously, the first electrode being disposed above the first insulation layer, and the gate electrode being disposed above the second insulation layer.

19. The method according to claim 16, further comprising: forming a shallow trench isolation unit by a shallow trench isolation process, the shallow trench isolation unit being configured to isolate the anti-fuse capacitor from an adjacent anti-fuse capacitor thereof.

20. The method according to claim 16, wherein the electrically connecting the first doped region to the first electrode by the back-end-of-line machining process comprises: forming a first metal connection hole by the back-end-of-line machining process to connect the first doped region to the first electrode by the first metal connection hole.

21. The method according to claim 20, wherein the first metal connection hole is a shared connection hole, the first doped region and the first electrode sharing the shared connection hole to be connected to the first doped region and the first electrode by the shared connection hole.

22. The method according to claim 16, further comprising: forming a second metal connection hole and a connection line layer by the back-end-of-line machining process, the second metal connection hole being configured to connect the second doped region to the metal connection line layer, or configured to connect the gate electrode to the metal connection line layer.

23. A storage apparatus, comprising the anti-fuse according to any one of claims 1 to 15.
